# EUROPEAN PATENT APPLICATION

(11) **EP 4 498 762 A1**
(43) Date of publication of application: **29.01.2025**
(21) Application number: 23306285.0
(22) Date of filing: 25.07.2023
(51) Int. Cl.: H05K 1/02

(54) **MULTILAYER PRINTED CIRCUIT BOARD WITH FILLING SEGMENT STRUCTURES**

(71) Applicant: Wolfspeed, Inc., Durham, NC 27703 (US)
(72) Inventor: BOUISSE, Gérard, 31470 Saint-Lys (FR)
(74) Representative: Boult Wade Tennant LLP

(57) **Abstract**

Multilayer printed circuit boards are provided. In one example, a multilayer printed circuit board 100 includes at least one metallization layer 110, 120, 130. The multilayer printed circuit board includes an insulating layer 102, 104. The at least one metallization layer includes a plurality of filling segment structures such that the at least one metallization layer has a metal density of at least about 35%.

## Description

### FIELD

The present disclosure relates generally to printed circuit boards.

### BACKGROUND

Multilayer printed circuit boards (PCBs) may be used in electronic devices. For instance, multilayer PCBs may be used in high performance radio frequency (RF) devices to provide efficient communication and/or processing of RF signals. As electronic devices become increasingly complex, the demand for multilayer PCBs with higher circuit densities, finer trace widths, and reduced interconnect lengths continues to rise. To meet these requirements, advanced fabrication techniques have been developed, including the semi-additive process (SAP) and the modified semi-additive process (MSAP).

### SUMMARY

Aspects and advantages of embodiments of the present disclosure will be set forth in part in the following description, or may be learned from the description, or may be learned through practice of the embodiments.

One example aspect of the present disclosure is directed to a multilayer printed circuit board. The multilayer printed circuit board includes at least one metallization layer. The multilayer printed circuit board includes an insulating layer. The multilayer printed circuit board includes an insulating layer. The at least one metallization layer includes a plurality of filling segment structures such that the at least one metallization layer has a metal density of at least about 35%.

Another example aspect of the present disclosure is directed to a multilayer printed circuit board. The multilayer printed circuit board includes a first metallization layer. The first metallization layer includes a radio frequency (RF) circuit pattern. The multilayer printed circuit board includes a second metallization layer. The second metallization layer includes a ground plane. The multilayer printed circuit board includes one or more inner metallization layers between the first metallization layer and the second metallization layer. The one or more inner metallization layers include a plurality of filling segment structures are arranged at least partially in a repeating pattern.

Another example aspect of the present disclosure is directed to a multilayer printed circuit board for a radio frequency (RF) device. The multilayer printed circuit board includes a first metallization layer. The first metallization layer includes a metal pattern. The multilayer printed circuit board includes a first insulating layer on the first metallization layer. The multilayer printed circuit board includes a second metallization layer on the first insulating layer. The second metallization layer includes a ground plane. The multilayer printed circuit board includes a second insulating layer on the second metallization layer. The multilayer printed circuit board includes a third metallization layer on the first insulating layer. The third metallization layer includes a first plurality of filling segment structures. The multilayer printed circuit board includes a third insulating layer on the third metallization layer. The multilayer printed circuit board includes a fourth metallization layer on the third insulating layer. The fourth metallization layer includes a second plurality of filling segment structures. The multilayer printed circuit board includes a fourth insulating layer on the fourth metallization layer. The multilayer printed circuit board includes a fifth metallization layer on the fourth insulating layer. The fifth metallization layer includes an RF circuit pattern.

These and other features, aspects and advantages of various embodiments will become better understood with reference to the following description and appended claims. The accompanying drawings, which are incorporated in and constitute a part of this specification, illustrate embodiments of the present disclosure and, together with the description, explain the related principles.

### BRIEF DESCRIPTION OF THE DRAWINGS

Detailed discussion of embodiments directed to one of ordinary skill in the art are set forth in the specification, which refers to the appended figures, in which:
FIG. 1 depicts an exploded cross-sectional view of an example multilayer PCB according to example embodiments of the present disclosure.
FIG. 2 depicts a plan view of an example metallization layer of a multilayer printed circuit board according to example embodiments of the present disclosure;
FIG. 3 depicts a plan view of an example metallization layer of a multilayer printed circuit board according to example embodiments of the present disclosure;
FIG. 4 depicts a plan view of an example metallization layer of a multilayer printed circuit board according to example embodiments of the present disclosure;
FIG. 5 depicts a plan view of an example metallization layer of a multilayer printed circuit board according to example embodiments of the present disclosure;
FIG. 6 depicts a plan view of an example metallization layer of a multilayer printed circuit board according to example embodiments of the present disclosure;
FIG. 7 depicts a plan view of an example metallization layer of a multilayer printed circuit board according to example embodiments of the present disclosure;
FIG. 8 depicts an exploded cross-sectional view of an example multilayer PCB according to example embodiments of the present disclosure.
FIG. 9 depicts a plan view of an example metallization layer of a multilayer printed circuit board according to example embodiments of the present disclosure;
FIG. 10 depicts a plan view of an example metallization layer of a multilayer printed circuit board according to example embodiments of the present disclosure;
FIG. 11 depicts a plan view of an example metallization layer of a multilayer printed circuit board according to example embodiments of the present disclosure;
FIG. 12 depicts a plan view of an example metallization layer of a multilayer printed circuit board according to example embodiments of the present disclosure; and
FIG. 13 depicts a plan view of an example metallization layer of a multilayer printed circuit board according to example embodiments of the present disclosure.

### DETAILED DESCRIPTION

Reference now will be made in detail to embodiments, one or more examples of which are illustrated in the drawings. Each example is provided by way of explanation of the embodiments, not limitation of the present disclosure. In fact, it will be apparent to those skilled in the art that various modifications and variations can be made to the embodiments without departing from the scope or spirit of the present disclosure. For instance, features illustrated or described as part of one embodiment can be used with another embodiment to yield a still further embodiment. Thus, it is intended that aspects of the present disclosure cover such modifications and variations.

Multilayer PCBs used in, for instance, RF applications may include multiple metallization layers that are separated by one or more insulating layers (e.g., dielectric layers) that are stacked together to form a PCB stack. The metallization layers may include metal structures, such as copper structures that provide good electrical conductivity. For instance, in some examples, a multilayer PCB may include a metallization layer that includes an RF circuit pattern, a metallization layer that includes, for instance, a ground plane, and/or a metallization layer that includes structures for connection to external devices (e.g., solder pads). The multilayer PCB may include one or more inner metallization layers in the PCB stack. Inner metallization layers of a PCB stack are metallization layers that are located between two dielectric layers and/or do not have any exposed metal structures.

In some examples, multilayer PCBs may be fabricated, at least in part, using subtractive processes, additive processes, and/or semi-additive processes such as SAP and/or MSAP. Under a subtractive process, a metal layer (e.g., copper layer) may be deposited on, for instance, an insulating layer. The metal layer may then be etched or otherwise have portions removed to form desired patterns (e.g., circuit patterns). Under an additive process, metal structures are added to the insulating layer to form the desired patterns (e.g., circuit patterns). Under a semi-additive process (e.g., MSAP), metal structures may be selectively applied to specific areas to provide under a combination of subtractive and additive steps, leading to greater flexibility in PCB design and the ability to create finer geometries.

In some PCB applications, certain metallization layers in the PCB stack may be required to have a certain metal density. Metal density refers to the percentage area of metal in a metallization layer relative to the total area (e.g., surface area) of one of the layers of the PCB. In some examples, metallization layers may be required to have higher metal density to reduce PCB warpage. In addition, degassing holes may be required to be implemented in the metal structures of the metallization layers. The degassing holes may allow for trapped gas to escape during fabrication, reducing delamination of the metal structures.

Increasing metal density of metallization layers in a multilayer PCB may interfere with desired circuit performance. For instance, large metal planes implemented to meet metal density requirements may perturbate desired circuit performance (e.g., RF circuit performance). Moreover, placement of degassing holes may result in perturbation of return currents and can lead to further design challenges.

Aspects of the present disclosure are discussed with reference to PCBs having at least one metallization layer that has a plurality of filling segment structures. Filling segment structures are small (e.g., relative to PCB surface area) metal structures (e.g., polygonal metal tile structures) that are implemented in a metallization layer and provide increased metal density for the metallization layer. The filling segment structures may be separated from one another by a small spacing. The small spacing can provide a path for degassing so that degassing holes are not required to be implemented in the metallization layer.

The filling segment structures may be metal structures in a metallization layer that fill space in the metallization layer. In some examples, the filling segment structures form a repeating pattern of shapes in at least one direction. In some examples, the filling segment structures are not conductively coupled to circuit paths or circuit patterns in the metallization layer or to electrical components on the PCB.

The filling segment structures may form a pattern that acts as a larger filling structure. The filling segment structures may form a pattern of identical filling tile structures of the same material and/or same shape. The filling segment structures may form an irregular pattern of the same or different sizes and include the same and/or different material to form the larger filling structure for the metallization layer.

For instance, in some examples, a PCB may have at least one metallization layer. The at least one metallization layer may have a plurality of filling segment structures (e.g., filling tile structures) such that the at least one metallization layer has a metal density of at least about 35%, such as at least about 50%, such as at least about 75%. The plurality of filling segment structures may be spaced apart at regular intervals, for instance, in a grid pattern. A spacing between adjacent filling segment structures may be much smaller than a size (e.g., length dimension and/or width dimension) of the filling segment structures, such as about 25% of a length dimension and a width dimension of a filling segment structure, such as about 10% of a length dimension and a width dimension of the filling segment structures.

In some examples, each filling segment structure may have a surface area that is much smaller than a surface area associated with the PCB, such as about 5% or less of the surface area of the PCB, such as about 1% or less of the surface area of the PCB. In this way, there may be 20 or more filing tile structures in a metallization layer, such as 50 or more filling segment structures, such as 70 or more filling segment structures, such as 100 or more filling segment structures, such as 200 or more filling segment structures, such as 500 or more filling segment structures.

In some examples, each filling segment structure may be a square shape or other suitable shape (e.g., polygonal shape such as a hexagon shape). Each filling segment structure may have a width dimension in a range of about 100 microns to about 750 microns, such as about 300 microns to about 600 microns, such as about 450 microns to about 550 microns. A spacing between adjacent filling segment structures may be about 25 microns to about 125 microns, such as about 35 microns to 100 microns, such as about 50 microns to about 100 microns.

Aspects of the present disclosure provide a number of technical effects and benefits. For instance, the filling segment structures may be used to achieve metal density requirements for metallization layers in a multilayer printed circuit board (e.g., metal density requirements for one or more inner metallization layers of the printed circuit board). The disturbance to the circuit (e.g., RF circuit) created by filling segment structures is negligible compared to large metal planes. The spacing between the filling segment structures may provide an evenly distributed degassing path without requiring degassing holes.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of the present disclosure. As used herein, the term "and/or" includes any and all combinations of one or more of the associated listed items.

The terminology used herein is for the purpose of describing particular embodiments only and is not intended to be limiting of the disclosure. As used herein, the singular forms "a," "an" and "the" are intended to include the plural forms as well, unless the context clearly indicates otherwise. It will be further understood that the terms "comprises" "comprising," "includes" and/or "including" when used herein, specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this disclosure belongs. It will be further understood that terms used herein should be interpreted as having a meaning that is consistent with their meaning in the context of this specification and the relevant art and will not be interpreted in an idealized or overly formal sense unless expressly so defined herein.

It will be understood that when an element such as a layer, region, or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

Relative terms such as "below" or "above" or "upper" or "lower" or "horizontal" or "lateral" or "vertical" may be used herein to describe a relationship of one element, layer or region to another element, layer or region as illustrated in the figures. It will be understood that these terms are intended to encompass different orientations of the device in addition to the orientation depicted in the figures.

Embodiments of the disclosure are described herein with reference to cross-section illustrations that are schematic illustrations of idealized embodiments (and intermediate structures) of the disclosure. The thickness of layers and regions in the drawings may be exaggerated for clarity. Additionally, variations from the shapes of the illustrations as a result, for example, of manufacturing techniques and/or tolerances, are to be expected. Thus, embodiments of the disclosure should not be construed as limited to the particular shapes of regions illustrated herein but are to include deviations in shapes that result, for example, from manufacturing. Similarly, it will be understood that variations in the dimensions are to be expected based on standard deviations in manufacturing procedures. As used herein, "approximately" or "about" includes values within 10% of the nominal value.

Like numbers refer to like elements throughout. Thus, the same or similar numbers may be described with reference to other drawings even if they are neither mentioned nor described in the corresponding drawing. Also, elements that are not denoted by reference numbers may be described with reference to other drawings.

Some embodiments of the disclosure are described with reference to semiconductor layers and/or regions which are characterized as having a conductivity type such as n type or p type, which refers to the majority carrier concentration in the layer and/or region. Thus, N type material has a majority equilibrium concentration of negatively charged electrons, while P type material has a majority equilibrium concentration of positively charged holes. Some material may be designated with a "+" or "-" (as in N+, N-, P+, P-, N++, N--, P++, P--, or the like), to indicate a relatively larger ("+") or smaller ("-") concentration of majority carriers compared to another layer or region. However, such notation does not imply the existence of a particular concentration of majority or minority carriers in a layer or region.

In the drawings and specification, there have been disclosed typical embodiments and, although specific terms are employed, they are used in a generic and descriptive sense only and not for purposes of limitation of the scope set forth in the following claims.

With reference now to the Figures, example embodiments of the present disclosure will now be set forth.

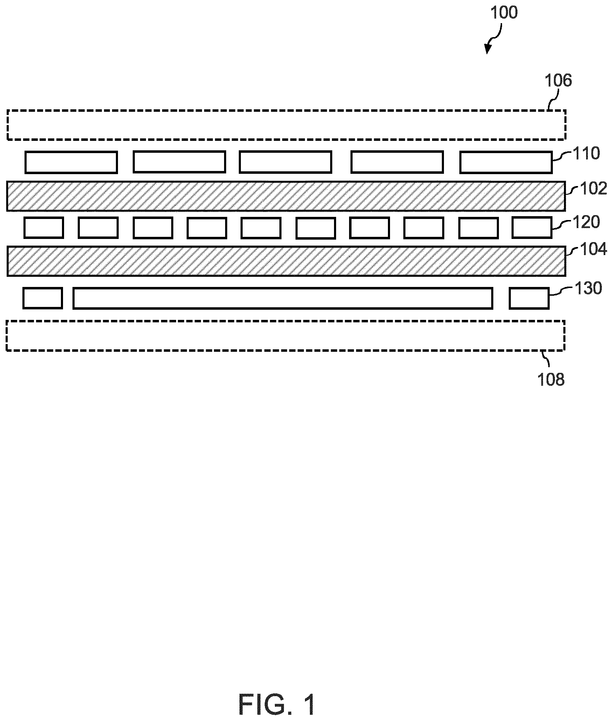

FIG. 1 depicts an exploded cross-sectional view of example multilayer PCB 100 according to example embodiments of the present disclosure. FIG. 1 is intended to represent structures for identification and description and is not intended to represent the structures to physical scale.

The multilayer PCB 100 includes at least one metallization layer and a dielectric layer. More particularly, the multilayer PCB 100 includes a first metallization layer 110, a second metallization layer 120, and a third metallization layer 130. The first metallization layer 110 may be on the insulating layer 102. The first metallization layer 110 may include a plurality of metal structures (e.g., copper structures) formed in a pattern. The metal structures may be formed on the insulating layer 102 using a subtractive process, additive process, semi-additive process, or other suitable process to form the first metallization layer 110.

Similarly, the second metallization layer 120 may include a plurality of metal structures (e.g., copper structures) formed in a pattern. The metal structures may be formed on the insulating layer 102 and/or insulating layer 104 using a subtractive process, additive process, semi-additive process, or other suitable process to form the second metallization layer 120. The second metallization layer 120 may be an inner metallization layer.

Similarly, the third metallization layer 130 may include a plurality of metal structures (e.g., copper structures) formed in a pattern. The metal structures may be formed on the insulating layer 104 using a subtractive process, additive process, semi-additive process, or other suitable process to form the third metallization layer 130.

The insulating layer 102 and the insulating layer 104 may each include a dielectric material. The insulating layer 102 and the insulating layer 104 may be the same material or may include different materials, including composite materials. Example materials for the insulating layer 102 and the insulating layer 104 include laminate materials (e.g., epoxy-based glass fiber laminate materials), polyimide, polytetrafluoroethylene (PTFE), ceramic-based materials, low loss thermoset materials, or other suitable dielectric materials. Those of ordinary skill in the art, using the disclosures provided herein, will understand that any suitable dielectric material may be used for the insulating layer 102 and the insulating layer 104 without deviating from the scope of the present disclosure.

In some examples, the insulating layer 102 and the insulating layer 104 may have the same thickness or may have different thicknesses. In some examples, the insulating layer 102 and the insulating layer 104 may each have a thickness in a range of about 25 microns to about 100 microns.

In some examples, the PCB 100 may include a solder mask 106 on the first metallization layer 110. The solder mask 106 may protect some or all of the first metallization layer 110 from environmental exposure. Similarly, the PCB 100 may include a solder mask 108. The solder mask 108 may protect some or all of the third metallization layer 130 from environmental exposure.

The first metallization layer 110, the second metallization layer 120, and the third metallization layer 130 may have any suitable pattern of metal structures (e.g., copper structures). According to example embodiments, as will be discussed in more detail below, at least one of the first metallization layer 110, the second metallization layer 120, and the third metallization layer 130 includes a plurality of filling segment structures.

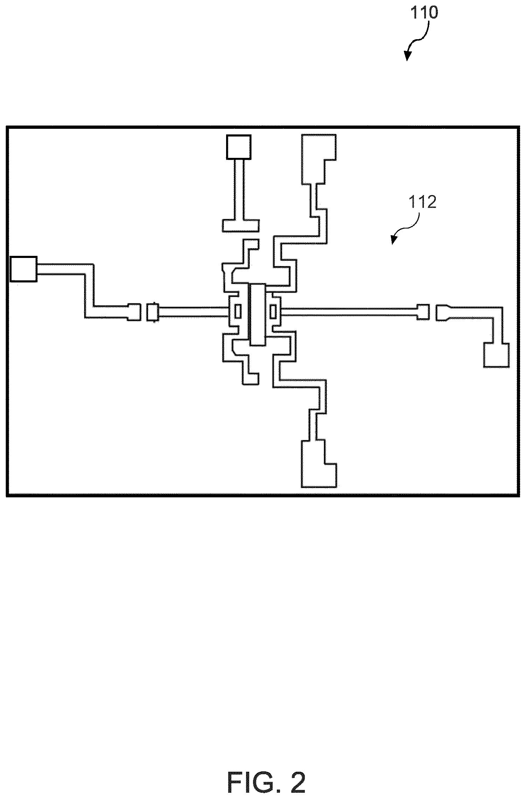

FIG. 2 depicts a plan view of an example first metallization layer 110 according to example embodiments of the present disclosure. As shown, the first metallization layer 110 includes a circuit pattern 112. The circuit pattern 112 may be an RF circuit pattern 112 and may include, for instance, microstrips, transmission lines, lumped impedance elements (e.g., inductors, capacitors), for communication of RF signals. FIG. 2 depicts one example circuit pattern that may be formed as part of the first metallization layer 110 for example purposes. Those of ordinary skill in the art, using the disclosures provided herein, will understand that any suitable circuit pattern may be used without deviating from the scope of the present disclosure.

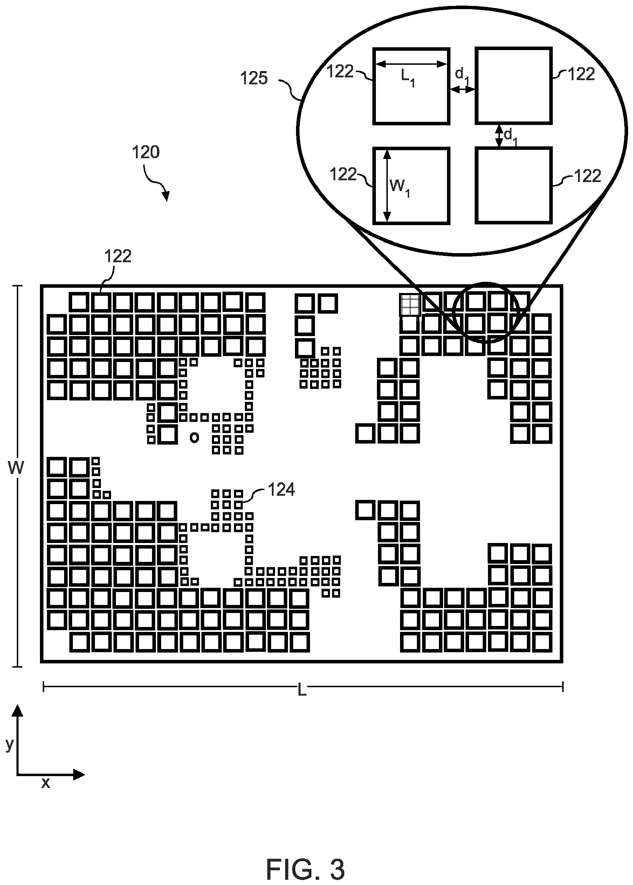

FIG. 3 depicts a plan view of an example second metallization layer 120, which is an inner metallization layer for the PCB 100. The second metallization layer 120 includes a plurality of filling segment structures 122. Each filling segment structure 122 is a small metal structure (e.g., copper structure) having a similar or identical shape (e.g., polygonal shape, square shape, hexagonal shape, etc.). In the example of FIG. 3, each filling segment structure 122 has a square shape. In some examples, the plurality of filling segment structures 122 can each have the same size (e.g., the same length l₁ and the same width w₁). In the example of FIG. 3, the second metallization layer 120 includes a first set of filling segment structures 122 with a first size and a second set of filling segment structures 124 with a smaller size. The filling segment structures 122 and the filling segment structures 124 may together form an irregular pattern with filling segment structures of different sizes. However, a portion of the filling segment structures 122 and a portion of the filling segment structures 124 may form a regular pattern of repeating filling segment structures over at least a portion of the metallization layer 120.

Each individual filling segment structure 122 may have a significantly small footprint relative to the size of the second metallization layer 120. For instance, the second metallization layer 120 may have a surface area defined by a length L along the x-axis and width w along the y-axis of the PCB 100. The length L can be the long dimension of the PCB 100. The surface area of the PCB 100 may be determined by multiplying the length L and the width W of the PCB 100. Each individual filling segment structure 122 may have a surface area that about 5% or less of the surface area of the PCB 100, such as about 1% or less of the surface area of the PCB 100, such as about 0.5% or less of the surface area of the PCB. In this way, the second metallization layer 120 may include about 20 or more filling segment structures 122, such as about 50 or more filling segment structures 122, such as about 100 or more filling segment structures 122, such as about 200 or more filling segment structures 122, such as about 500 or more filling segment structures 122.

As shown in the close up view 125 of example filling segment structures 122, each filling file structure 122 has a length l₁ and a width w₁. In the example of FIG. 3, the length l₁ and the width w₁ are approximately equal. The length l₁ and/or the width w₁ may be in a range of about 100 microns to about 750 microns, such as about 300 microns to about 600 microns, such as about 450 microns to about 550 microns.

For at least a portion of the pattern, each of the plurality of filling segment structures 122 (and plurality of filling segment structures 124) may be spaced apart at regular intervals (e.g., having uniform spacing between adjacent filling segment structures 124). For instance, a spacing d1 between adjacent filling segment structures 122 (in the x-direction and in the y-direction) may be about equal and may be in a range of 25 microns to about 125 microns, such as about 35 microns to 100 microns, such as about 50 microns to about 100 microns.

The plurality of filling segment structures 122 and the plurality of filling segment structures 124 may fill at least a portion of the surface area of the PCB 100 in the metallization layer 120. For instance, the filling segment structures 122 and the filling segment structures 124 may fill at least about 35% of the surface area of the PCB 100, such as at least about 50% of the surface area of the PCB 100, such as at least about 75% of the surface area of the PCB. In this way, the filling segment structures 122 and the filing tile structures 124 may provide a certain metal density for the metallization layer 120, such as a metal density of at least about 35%, such as at least about 50%, such as at least about 75%.

At least a portion of the plurality of filling segment structures 122 and/or the plurality of filling segment structures 124 are arranged in a grid pattern. More specifically, the filling segment structures 122 may be arranged in vertical and/or horizontal lines. For instance, a grid pattern may include at least three filling segment structures aligned in a vertical line and at least three filling segment structures aligned in a horizontal line that is generally perpendicular to the horizontal line. The grid pattern may provide a precise and structured layout for the plurality of filling segment structures 122 and filling segment structures 124.

The spacing between the plurality of filling segment structures 122 and the plurality of filling segment structures 124 may accommodate degassing during PCB fabrication. In this way, the metallization layer 120 may not have any degassing holes in the metal structures in the metallization layer 120.

The plurality of filling segment structures 122 and the plurality of filling segment structures 124 may be additive process defined filling segment structures 122. More specifically, the plurality of filling segment structures 122 and the plurality of filling segment structures 124 may be formed using an additive process (e.g., MSAP process). However, in some examples, the plurality of filling segment structures 122 and/or the plurality of filling segment structures 124 may be formed using a subtractive process.

In the example of FIG. 3, the plurality of filling segment structures 122 and the plurality of filling segment structures 124 are arranged such that the filling segment structures 122 and the filling segment structures 124 do not overlap the circuit pattern 112 in the first metallization layer 110. As used herein, a first structure "at least partially overlaps" a second structure if an axis that is perpendicular to a major surface of the first structure passes through both the first structure and the second structure. In some examples, the plurality of filling segment structures 122 may at least partially overlap one or more portions of the circuit pattern 112 in the first metallization layer 110.

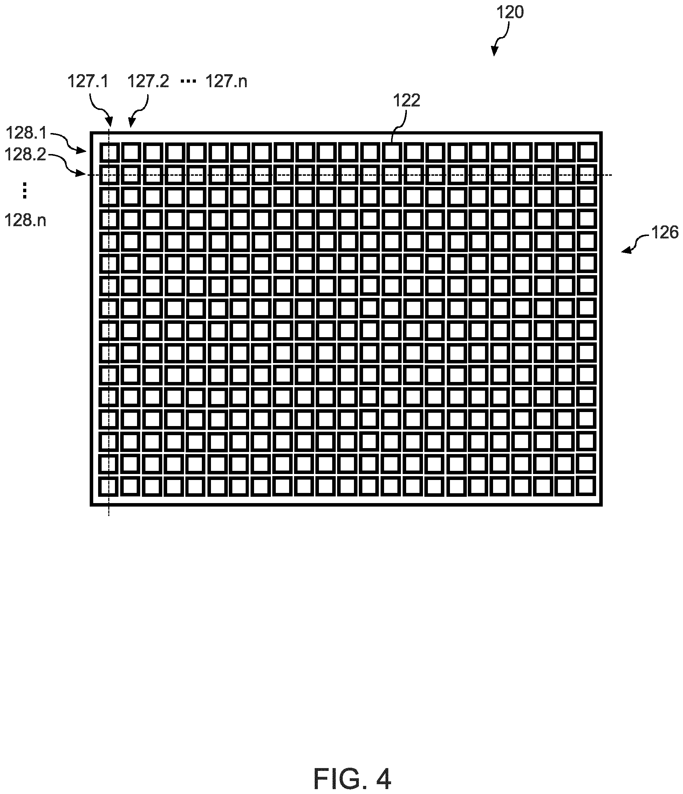

For instance, FIG. 4 depicts an example second metallization layer 120 with a pattern of filling segment structures 122 according to example embodiments of the present disclosure. In the example of FIG. 4, the plurality of filling segment structures 122 includes a plurality of square filling segment structures arranged in a grid array pattern 126. The grid array pattern 126 includes a plurality of vertical columns 127.1, 127.2, 127.3, ... 127.n and in a plurality of horizontal rows 128.1, 128.2, 128.3, ... 128.n. The grid array pattern 126 takes up at least about 75% of the surface area of the PCB 100 in the second metallization layer 120. The filling segment structures 122 in the example second metallization layer 120 of FIG. 4 at least partially overlap of the circuit pattern 112 in the first metallization layer 110 of the PCB 100.

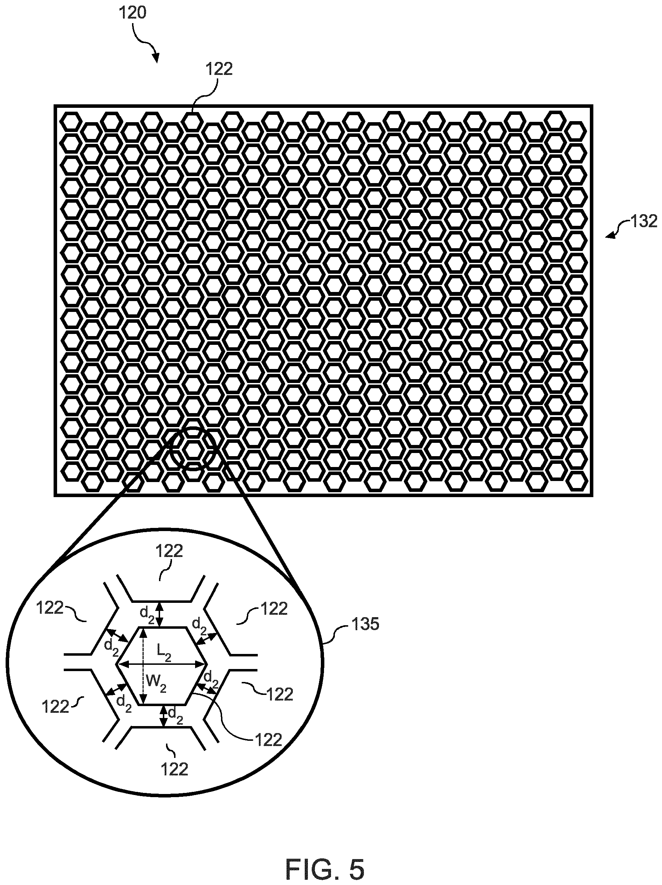

FIG. 5 depicts an example second metallization layer 120 with a pattern of filling segment structures 122 according to example embodiments of the present disclosure. In the example of FIG. 5, the plurality of filling segment structures 122 includes a plurality of hexagon shaped filling segment structures arranged in a hexagonal tile pattern 132. The hexagonal tile pattern 132 takes up at least about 75% of the surface area of the PCB 100 in the second metallization layer 120. The filling segment structures 122 in the example second metallization layer 120 of FIG. 5 at least partially overlap the circuit pattern 112 in the first metallization layer 110 of the PCB 100.

As shown in the close up view 135 of example filling segment structures 122 in the hexagonal tile pattern 132. Each filling file structure 122 has a length l₂ and a width w₂. The length l₂ may be longer than the width w₂ and may be the long dimension of the filling segment structure 122. The length l₂ and/or the width w₂ may be in a range of about 100 microns to about 750 microns, such as about 300 microns to about 600 microns, such as about 450 microns to about 550 microns.

For at least a portion of the hexagonal grid pattern 132, each of the plurality of filling segment structures 122 may be spaced apart at regular intervals (e.g., having uniform spacing between adjacent filling segment structures 122). In the hexagonal tile pattern 132, a filling segment structure 122 may be adjacent to six other filling segment structures 122 by a spacing d2. The spacing d2 may be uniform or about equal between all adjacent filling segment structures. The spacing d2 may be, for instance, in a range of 25 microns to about 125 microns, such as about 35 microns to 100 microns, such as about 50 microns to about 100 microns.

FIGS. 3-5 depict example patterns and shapes for a plurality of filling tiles 122 for purposes of illustration and discussion. Those of ordinary skill in the art, using the disclosures provided herein, will understand that other patterns and shapes of filling tiles 122 may be used without deviating from the scope of the present disclosure.

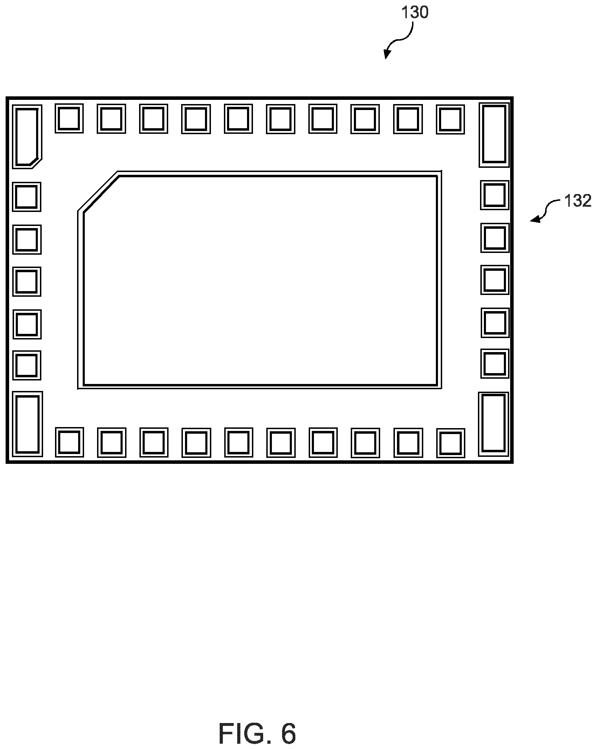

FIG. 6 depicts a plan view of an example third metallization layer 130 according to example embodiments of the present disclosure. As shown, the third metallization layer 130 includes a pattern 134 of metal structures (e.g., copper structures). In some examples, the pattern 134 may include pads (e.g., solder pads) for connection to external components. FIG. 6 depicts one example pattern 134 that may be formed as part of the third metallization layer 130 for example purposes. Those of ordinary skill in the art, using the disclosures provided herein, will understand that any suitable circuit pattern may be used without deviating from the scope of the present disclosure.

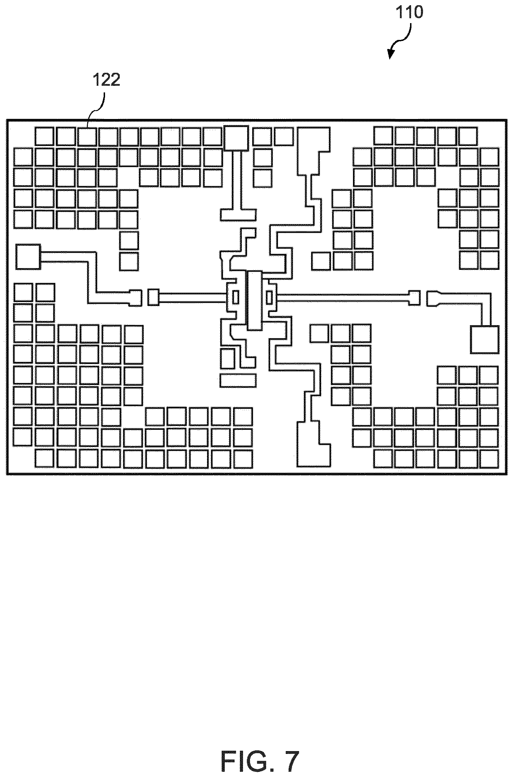

In some examples, the PCB 100 may include filling segment structures on other metallization layers, such as the first metallization layer 110 and/or the third metallization layer 130. For instance, FIG. 7 depicts a plan view of a first metallization layer 110 of PCB 100 according to example embodiments of the present disclosure. As shown, the first metallization layer 110 may include the circuit pattern 112 (e.g., an RF circuit pattern 112) and a plurality of filling tiles 122 (e.g., in a similar pattern to that described with reference to the second metallization layer 120 shown in FIG. 3). The plurality of filling tiles 122 may be incorporated into the metallization layer 110, for instance, to achieve a desired metal density for the metallization layer 110.

The examples described with reference to FIGS. 1-7 are related to a PCB 100 with three metallization layers for purposes of illustration and discussion. Those of ordinary skill in the art, using the disclosures provided herein, will understand that aspects of the present disclosure may be incorporated into PCBs with any number of metallization layers.

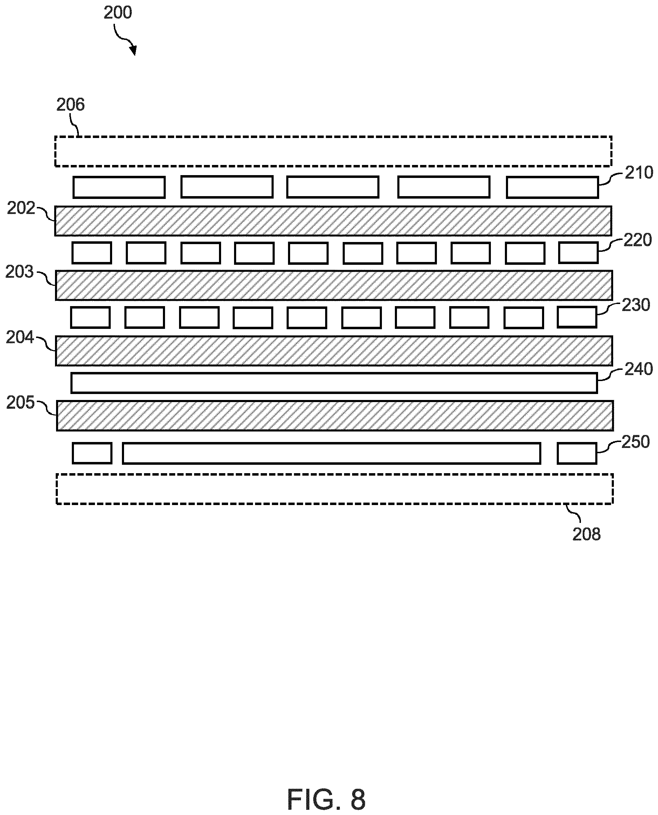

For instance, FIG. 8 depicts an exploded cross-sectional view of an example multilayer PCB 200 with five metallization layers. FIG. 8 is intended to represent structures for identification and description and is not intended to represent the structures to physical scale.

The multilayer PCB 200 includes a first metallization layer 210, a second metallization layer 220, a third metallization layer 230, a fourth metallization layer 240, and a fifth metallization layer 250. The first metallization layer 210 may be on the insulating layer 202. The first metallization layer 210 may include a plurality of metal structures (e.g., copper structures) formed in a pattern. The metal structures may be formed on the insulating layer 202 using a subtractive process, additive process, semi-additive process, or other suitable process to form the first metallization layer 210.

Similarly, the second metallization layer 220 may include a plurality of metal structures (e.g., copper structures) formed in a pattern. The metal structures may be formed on the insulating layer 202 and/or insulating layer 203 using a subtractive process, additive process, semi-additive process, or other suitable process to form the second metallization layer 220. The second metallization layer 220 may be an inner metallization layer.

Similarly, the third metallization layer 230 may include a plurality of metal structures (e.g., copper structures) formed in a pattern. The metal structures may be formed on the insulating layer 203 and/or insulating layer 204 using a subtractive process, additive process, semi-additive process, or other suitable process to form the third metallization layer 230. The third metallization layer 230 may be an inner metallization layer.

Similarly, the fourth metallization layer 240 may include a plurality of metal structures (e.g., copper structures) formed in a pattern. The metal structures may be formed on the insulating layer 204 and/or insulating layer 205 using a subtractive process, additive process, semi-additive process, or other suitable process to form the fourth metallization layer 240. The fourth metallization layer 240 may be an inner metallization layer.

Similarly, the fifth metallization layer 250 may include a plurality of metal structures (e.g., copper structures) formed in a pattern. The metal structures may be formed on the insulating layer 205 using a subtractive process, additive process, semi-additive process, or other suitable process to form the fifth metallization layer 250.

The insulating layer 202, the insulating layer 203, the insulating layer 204, and the insulating layer 205 may each include a dielectric material. The insulating layer 202, the insulating layer 203, the insulating layer 204, and the insulating layer 205 may be the same material or may include different materials, including composite materials. Example materials for the insulating layer 202, the insulating layer 203, the insulating layer 204, and the insulating layer 205 include laminate materials (e.g., epoxy-based glass fiber laminate materials), polyimide, polytetrafluoroethylene (PTFE), ceramic-based materials, low loss thermoset materials, or other suitable dielectric materials. Those of ordinary skill in the art, using the disclosures provided herein, will understand that any suitable dielectric material may be used for the insulating layer 202, the insulating layer 203, the insulating layer 204, and the insulating layer 205 without deviating from the scope of the present disclosure.

In some examples, the insulating layer 202, the insulating layer 203, the insulating layer 204, and the insulating layer 205 may have the same thickness or may have different thicknesses. In some examples, the insulating layer 202, the insulating layer 203, the insulating layer 204, and the insulating layer 205 may each have a thickness in a range of about 25 microns to about 100 microns.

In some examples, the PCB 200 may include a solder mask 206 on the first metallization layer 210. The solder mask 206 may protect some or all of the first metallization layer 210 from environmental exposure. Similarly, the PCB 200 may include a solder mask 208. The solder mask 208 may protect some or all of the fifth metallization layer 250 from environmental exposure.

The first metallization layer 210, the second metallization layer 220, the third metallization layer 230, the fourth metallization layer 240, and the fifth metallization layer 250 may have any suitable pattern of metal structures (e.g., copper structures). According to example embodiments, as will be discussed in more detail below, at least one of the first metallization layer 210, the second metallization layer 220, the third metallization layer 230, the fourth metallization layer 240, and the fifth metallization layer 250 includes a plurality of filling segment structures.

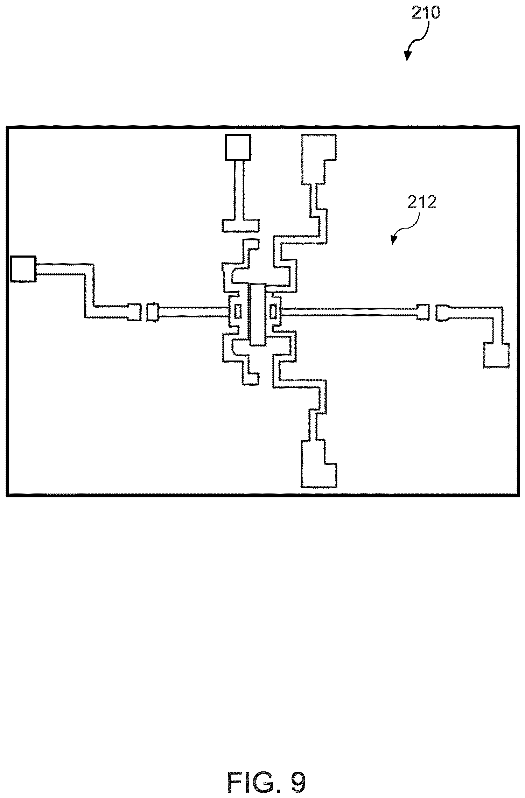

FIG. 9 depicts a plan view of an example first metallization layer 210 according to example embodiments of the present disclosure. As shown, the first metallization layer 210 includes a circuit pattern 212. The circuit pattern 212 may be an RF circuit pattern 212 and may include, for instance, microstrips, transmission lines, lumped impedance elements (e.g., inductors, capacitors), for communication of RF signals. FIG. 9 depicts one example circuit pattern that may be formed as part of the first metallization layer 210 for example purposes. Those of ordinary skill in the art, using the disclosures provided herein, will understand that any suitable circuit pattern may be used without deviating from the scope of the present disclosure.

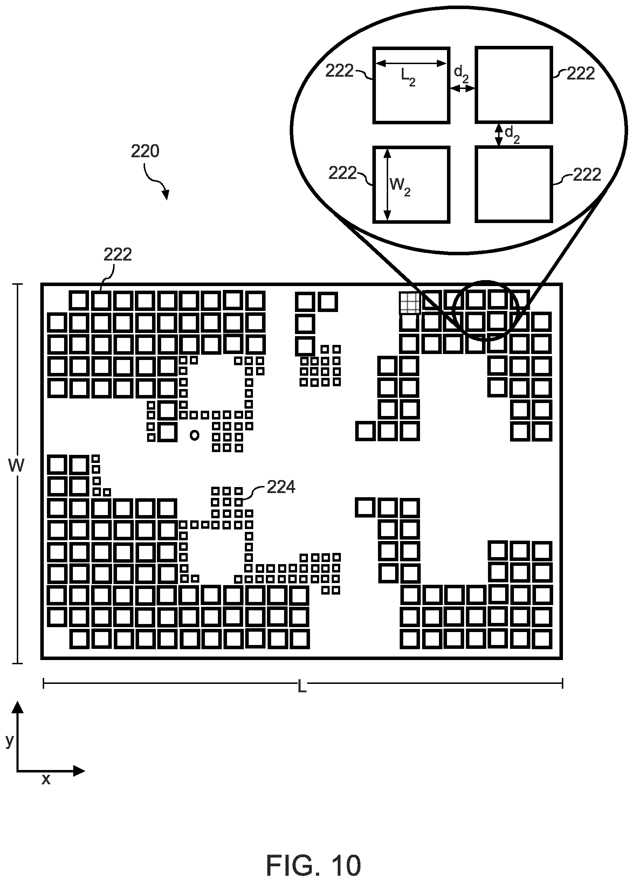

FIG. 10 depicts a plan view of an example second metallization layer 220 according to example embodiments of the present disclosure. The second metallization layer 220 includes a plurality of filling segment structures 222. Each filling segment structure 222 is a small metal structure (e.g., copper structure) having a similar or identical shape (e.g., polygonal shape, square shape, hexagonal shape, etc.).

In the example of FIG. 10, each filling segment structure 222 has a square shape. In some examples, the plurality of filling segment structures 222 can each have the same size (e.g., the same length l₁ and the same width w₁). In the example of FIG. 10, the second metallization layer 220 includes a first set of filling segment structures 222 with a first size and a second set of filling segment structures 224 with a smaller size.

Each individual filling segment structure 222 may have a significantly small footprint relative to the size of the second metallization layer 220. For instance, each individual filling segment structure 222 may have a surface area that about 5% or less of the surface area of the PCB 200, such as about 1% or less of the surface area of the PCB 200, such as about 0.5% or less of the surface area of the PCB. In this way, the second metallization layer 220 may include about 20 or more filling segment structures 222, such as about 50 or more filling segment structures 222, such as about 100 or more filling segment structures 222, such as about 200 or more filling segment structures 222, such as about 500 or more filling segment structures 222.

Each filling file structure 122 has a length l₁ and a width w₁. In the example of FIG. 10, the length l₁ and the width w₁ are approximately equal. The length l₁ and/or the width w₁ may be in a range of about 100 microns to about 750 microns, such as about 300 microns to about 600 microns, such as about 450 microns to about 550 microns.

For at least a portion of the pattern, each of the plurality of filling segment structures 222 (and the plurality of filling segment structures 224) may be spaced apart at regular intervals (e.g., having uniform spacing between adjacent filling segment structures 222). For instance, a spacing d1 between adjacent filling segment structures 222 (in the x-direction and in the y-direction) may be about equal and may be in a range of 25 microns to about 125 microns, such as about 35 microns to 100 microns, such as about 50 microns to about 100 microns.

The plurality of filling segment structures 222 and the plurality of filling segment structures 224 may fill at least a portion of the surface area of the PCB 200 in the metallization layer 220. For instance, the filling segment structures 222 and the filling segment structures 224 may fill at least about 35% of the surface area of the PCB 200, such as at least about 50% of the surface area of the PCB 100, such as at least about 75% of the surface area of the PCB. In this way, the filling segment structures 222 and the filing tile structures 224 may provide a certain metal density for the metallization layer 220, such as a metal density of at least about 35%, such as at least about 50%, such as at least about 75%.

At least a portion of the plurality of filling segment structures 222 and/or the plurality of filling segment structures 224 are arranged in a grid pattern. More specifically, the filling segment structures 222 may be arranged in vertical and/or horizontal lines. The grid pattern may provide a precise and structured layout for the plurality of filling segment structures 222 and the plurality of filling segment structures 224.

The spacing between the plurality of filling segment structures 222 and the plurality of filling segment structures224 may accommodate degassing during PCB fabrication. In this way, the metallization layer 220 may not have any degassing holes in the metal structures in the metallization layer 220.

The plurality of filling segment structures 222 and the plurality of filling segment structures 224 may be additive process defined filling segment structures 222. More specifically, the plurality of filling segment structures 222 and the plurality of filling segment structures 224 may be formed using an additive process (e.g., MSAP process). However, in some examples, the plurality of filling segment structures 222 and/or the plurality of filling segment structures 224 may be formed using a subtractive process.

In the example of FIG. 10, the plurality of filling segment structures 222 and the plurality of filling segment structures 224 are arranged such that the filling segment structures 222 and the filling segment structures 224 do not overlap the circuit pattern 212 in the first metallization layer 210. In some examples, the plurality of filling segment structures 222 may at least partially overlap one or more portions of the circuit pattern 212 in the first metallization layer 210.

FIG. 10 depicts one example pattern of filling segment structures that may be used in the second metallization layer 220. Those of ordinary skill in the art, using the disclosures provided herein, will understand that the second metallization layer 220 may include any pattern of filling segment structures, such as a grid array pattern of filling segment structures similar to that illustrated in FIG. 4 or a hexagonal tile pattern similar to that illustrated in FIG. 5.

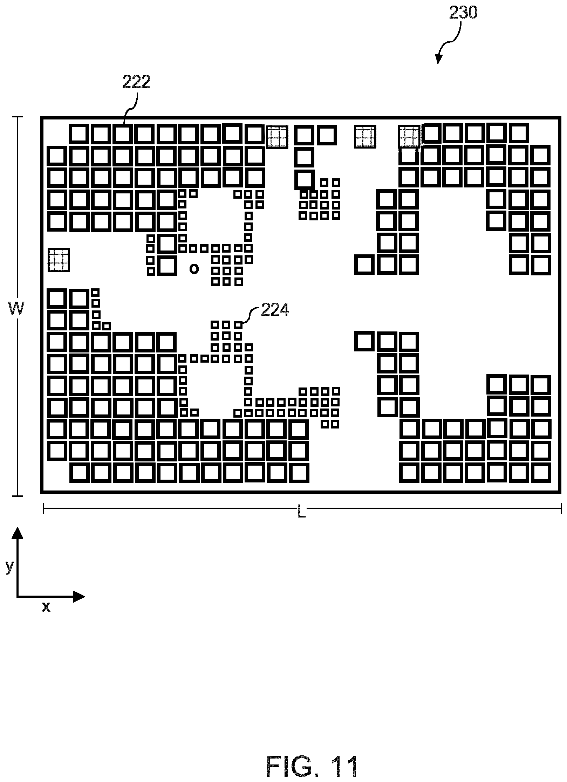

FIG. 11 depicts a plan view of an example third metallization layer 230 according to example embodiments of the present disclosure. The third metallization layer 230 includes a plurality of filling segment structures 222. In some examples, the third metallization layer 230 includes a pattern of filling segment structures 222 that is identical to the pattern of filling segment structures 222 in the second metallization layer 220 (e.g., the same pattern). In some examples, the pattern of filling segment structures 222 in the third metallization layer 230 may be different than the pattern of filling segment structures 222 in the second metallization layer 220.

FIG. 11 depicts one example pattern of filling segment structures that may be used in the second metallization layer 230. Those of ordinary skill in the art, using the disclosures provided herein, will understand that the second metallization layer 230 may include any pattern of filling segment structures, such as a grid array pattern of filling segment structures similar to that illustrated in FIG. 4 or a hexagonal tile pattern similar to that illustrated in FIG. 5.

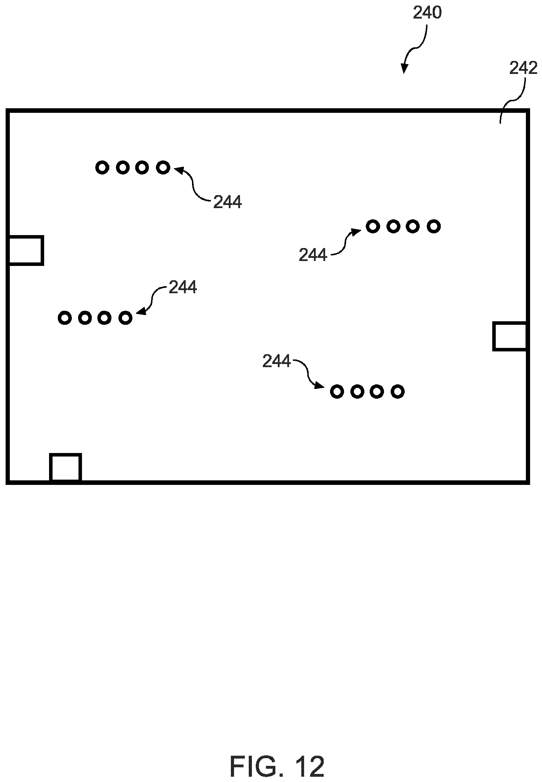

FIG. 12 depicts a plan view of an example fourth metallization layer 240 according to example embodiments of the present disclosure. The fourth metallization layer 240 may include a ground plane 242. The ground plane 242 may include a large sheet of metal (e.g., copper) that takes up a significant portion of the surface area of the PCB 200, such as at least about 75% of the surface area of the PCB without interruption. The fourth metallization layer 240 may include a plurality of degassing holes 244 to reduce delamination of the ground plane 242. FIG. 12 depicts one example metal pattern that may be formed as part of the fourth metallization layer 240 for example purposes. Those of ordinary skill in the art, using the disclosures provided herein, will understand that any suitable circuit pattern may be used without deviating from the scope of the present disclosure.

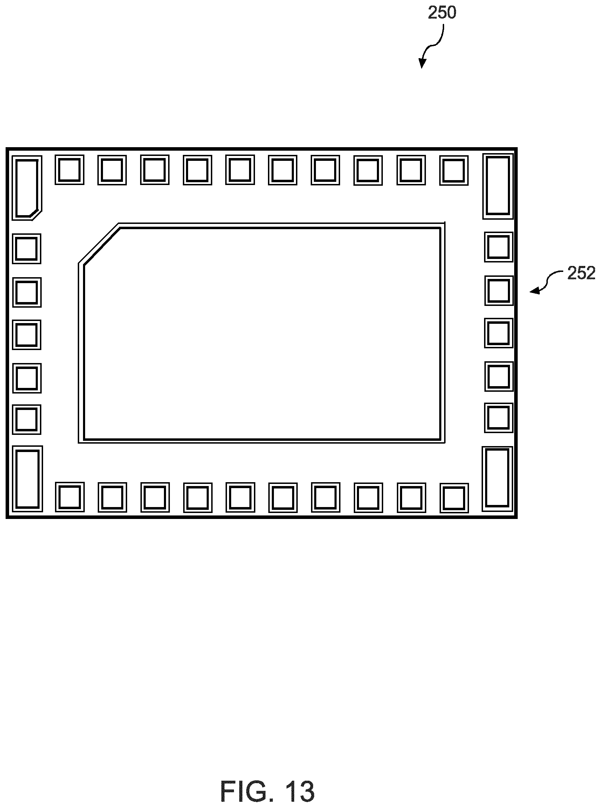

FIG. 13 depicts a plan view of an example fifth metallization layer 250 according to example embodiments of the present disclosure. As shown, the fifth metallization layer 250 includes a pattern 252 of metal structures (e.g., copper structures). In some examples, the pattern 252 may include pads (e.g., solder pads) for connection to external components. FIG. 13 depicts one example pattern 252 that may be formed as part of the fifth metallization layer 250 for example purposes. Those of ordinary skill in the art, using the disclosures provided herein, will understand that any suitable circuit pattern may be used without deviating from the scope of the present disclosure.

In some examples, the PCB 200 may include filling segment structures on other metallization layers, such as the first metallization layer 210 and/or the fifth metallization layer 250. For instance, the first metallization layer 210 may include the circuit pattern 212 (e.g., an RF circuit pattern 212) and a plurality of filling tiles 222 in a pattern similar to what is shown in FIG. 7.

Example aspects of the present disclosure are set forth below. Any of the below features or examples may be used in combination with any of the embodiments or features provided in the present disclosure.

One example aspect of the present disclosure is directed to a multilayer printed circuit board. The multilayer printed circuit board includes at least one metallization layer. The multilayer printed circuit board includes an insulating layer. The multilayer printed circuit board includes an insulating layer. The at least one metallization layer includes a plurality of filling segment structures such that the at least one metallization layer has a metal density of at least about 35%, such as at least about 50%, such as at least about 75%.

In some examples, each filling segment structure has a surface area of less than about 5% of a surface area of multilayer printed circuit board.

In some examples, the plurality of filling segment structures form a repeating pattern of identical shapes for at least a portion of the metallization layer.

In some examples, the plurality of filling segment structures are spaced apart at regular intervals. In some examples, the plurality of filling segment structures each have a width dimension and a length dimension, wherein a spacing between adjacent filling segment structures is less than about 25% of the width dimension and the length dimension, such as less than about 10% of the width dimension and the length dimension. In some examples, a spacing between adjacent filling segment structures is in a range of about 25 microns to about 125 microns. In some examples, a width dimension of the filling segment structures is in a range of about 100 microns to about 750 microns.

In some examples, each filling segment structure has a polygonal shape (e.g., hexagonal shape). In some examples, each filling segment structure has a square shape.

In some examples, the plurality of filling segment structures are at least partially arranged in a grid pattern.

In some examples, the metallization layer does not include any degassing holes.

In some examples, the metallization layer comprises a radio frequency circuit pattern.

In some examples, the plurality of filling segment structures are not conductively coupled to a circuit pattern in the printed circuit board.

In some examples, the metallization layer is an inner metallization layer of a plurality of metallization layers in a printed circuit board stack.

In some examples, the plurality of filling segment structures do not overlap a radio frequency circuit implemented in the multilayer printed circuit board.

In some examples, the plurality of filling segment structures at least partially overlaps a radio frequency circuit implemented in the multilayer printed circuit board.

In some examples, the plurality of filling segment structures are additive process defined structures.

In some examples, the plurality of filling segment structures are copper.

Another example aspect of the present disclosure is directed to a multilayer printed circuit board. The multilayer printed circuit board includes a first metallization layer. The first metallization layer includes a radio frequency (RF) circuit pattern. The multilayer printed circuit board includes a second metallization layer. The second metallization layer includes a ground plane. The multilayer printed circuit board includes one or more inner metallization layers between the first metallization layer and the second metallization layer. The one or more inner metallization layers include a plurality of filling segment structures are arranged at least partially in a repeating pattern.

In some examples, the plurality of filling segment structures form a repeating pattern of identical shapes for at least a portion of the metallization layer.

In some examples, each of the plurality of filling segment structures has a surface area of about 5% or less than a surface area of the multilayer printed circuit board. In some examples, the plurality of filling segment structures fill at least about 35% of a surface area of the multilayer printed circuit board, such as at least about 50% of a surface area of the multilayer printed circuit board, such as at least about 75% of a surface area of the multilayer printed circuit board.

In some examples, the plurality of filling segment structures are spaced apart at regular intervals. In some examples, the plurality of filling segment structures each have a width dimension and a length dimension, wherein a spacing between adjacent filling segment structures is less than about 25% of the width dimension and the length dimension, such as less than about 10% of the width dimension and the length dimension. In some examples, a spacing between adjacent filling segment structures is in a range of about 25 microns to about 125 microns. In some examples, a width dimension of the filling segment structures is in a range of about 100 microns to about 750 microns.

In some examples, each filling segment structure has a polygonal shape (e.g., hexagonal shape). In some examples, each filling segment structure has a square shape.

In some examples, the plurality of filling segment structures are at least partially arranged in a grid pattern.

In some examples, the one or more inner metallization layers do not include any degassing holes.

In some examples, the first metallization layer comprises a second plurality of filling segment structures.

In some examples, the one or more inner metallization layers have a metal density of at least about 75%.

In some examples, the plurality of filling segment structures do not overlap the RF circuit pattern implemented in the first metallization layer.

In some examples, the plurality of filling segment structures at least partially overlap the RF circuit pattern implemented in the first metallization layer.

In some examples, the plurality of filling segment structures are additive process defined structures.

In some examples, the plurality of filling segment structures are copper.

Another example aspect of the present disclosure is directed to a multilayer printed circuit board for a radio frequency (RF) device. The multilayer printed circuit board includes a first metallization layer. The first metallization layer includes a metal pattern. The multilayer printed circuit board includes a first insulating layer on the first metallization layer. The multilayer printed circuit board includes a second metallization layer on the first insulating layer. The second metallization layer includes a ground plane. The multilayer printed circuit board includes a second insulating layer on the second metallization layer. The multilayer printed circuit board includes a third metallization layer on the first insulating layer. The third metallization layer includes a first plurality of filling segment structures. The multilayer printed circuit board includes a third insulating layer on the third metallization layer. The multilayer printed circuit board includes a fourth metallization layer on the third insulating layer. The fourth metallization layer includes a second plurality of filling segment structures. The multilayer printed circuit board includes a fourth insulating layer on the fourth metallization layer. The multilayer printed circuit board includes a fifth metallization layer on the fourth insulating layer. The fifth metallization layer includes an RF circuit pattern.

In some examples, the first plurality of filling segment structures and the second plurality of filling segment structures form a repeating pattern of identical shapes for at least a portion of the metallization layer.

In some examples, the first plurality of filling segment structures and the second plurality of filling segment structures are arranged in the same pattern.

In some examples, the first plurality of filling segment structures and the second plurality of filling segment structures do not overlap the RF circuit pattern.

In some examples, the first plurality of filling segment structures and the second plurality of filing tile structures at least partially overlap the RF circuit pattern.

In some examples, the third metallization layer and the fourth metallization layer do not include any degassing holes.

In some examples, the second metallization layer includes a plurality of degassing holes.

In some examples, each of the plurality of filling segment structures has a surface area of about 5% or less than a surface area of the multilayer printed circuit board. In some examples, the plurality of filling segment structures fill at least about 35% of a surface area of the multilayer printed circuit board, such as at least about 50% of a surface area of the multilayer printed circuit board, such as at least about 75% of a surface area of the multilayer printed circuit board.

In some examples, the third metallization layer and the fourth metallization layer have a metal density of at least about 35%, such as at least about 50%, such as at least about 75%. In some examples, the second metallization layer has a metal density that is approximately equal to a metal density of the fourth metallization layer.

In some examples, the first plurality of filling segment structures and the second plurality of filling segment structures are spaced apart at regular intervals. In some examples, the first plurality of filling segment structures and the second plurality of filling segment structures each have a width dimension and a length dimension, wherein a spacing between adjacent filling segment structures is less than about 25% of the width dimension and the length dimension, such as less than about 10% of the width dimension and the length dimension. In some examples, a spacing between adjacent filling segment structures is in a range of about 25 microns to about 125 microns. In some examples, a width dimension of the filling segment structures is in a range of about 100 microns to about 750 microns.

In some examples, each of the first plurality of filling segment structures and each of the second plurality of filling segment structures has a polygonal shape (e.g., hexagonal shape). In some examples, each of the first plurality of filling segment structures and each of the second plurality of filling segment structures has a square shape.

In some examples, each of the first plurality of filling segment structures and each of the second plurality of filling segment structures are additive process defined structures.

In some examples, each of the first plurality of filling segment structures and each of the second plurality of filling segment structures are copper.

While the present subject matter has been described in detail with respect to specific example embodiments thereof, it will be appreciated that those skilled in the art, upon attaining an understanding of the foregoing may readily produce alterations to, variations of, and equivalents to such embodiments. Accordingly, the scope of the present disclosure is by way of example rather than by way of limitation, and the subject disclosure does not preclude inclusion of such modifications, variations and/or additions to the present subject matter as would be readily apparent to one of ordinary skill in the art.

## Claims

1. A multilayer printed circuit board, comprising:
at least one metallization layer;
an insulating layer; and
wherein the at least one metallization layer comprises a plurality of filling segment structures such that the at least one metallization layer has a metal density of at least about 35%.

2. The multilayer printed circuit board of claim 1, wherein each filling segment structure has a surface area of less than about 5% of a surface area of multilayer printed circuit board.

3. The multilayer printed circuit board of claim 1 or claim 2, wherein the plurality of filling segment structures form a repeating pattern of identical shapes for at least a portion of the metallization layer.

4. The multilayer printed circuit board of any preceding claim, wherein the plurality of filling segment structures are spaced apart at regular intervals.

5. The multilayer printed circuit board of any preceding claim, wherein the plurality of filling segment structures each have a width dimension and a length dimension, wherein a spacing between adjacent filling segment structures is less than about 25% of the width dimension and the length dimension.

6. The multilayer printed circuit board of any preceding claim, wherein a spacing between adjacent filling segment structures is in a range of about 25 microns to about 125 microns.

7. The multilayer printed circuit board of any preceding claim, wherein a width dimension of the filling segment structures is in a range of about 100 microns to about 750 microns.

8. The multilayer printed circuit board of any preceding claim, wherein each filling segment structure has a polygonal shape.

9. The multilayer printed circuit board of any of claims 1 to 7, wherein each filling segment structure has a square shape.

10. The multilayer printed circuit board of any preceding claim, wherein the plurality of filling segment structures are at least partially arranged in a grid pattern.

11. The multilayer printed circuit board of any preceding claim, wherein the metallization layer does not include any degassing holes.

12. The multilayer printed circuit board of any preceding claim, wherein the metallization layer comprises a radio frequency circuit pattern.

13. The multilayer printed circuit board of any preceding claim, wherein the metallization layer is an inner metallization layer of a plurality of metallization layers in a printed circuit board stack.

14. The multilayer printed circuit board of any preceding claim, wherein the plurality of filling segment structures are additive process defined structures.

15. The multilayer printed circuit board of any preceding claim, wherein the plurality of filling segment structures are copper.
